# EUROPÄISCHE PATENTSCHRIFT

(11) **EP 3 794 914 B1**
(45) Veröffentlichungstag und Bekanntmachung des Hinweises auf die Patenterteilung: **08.03.2023**
(21) Anmeldenummer: 19723128.5
(22) Anmeldetag: 14.05.2019
(51) Int. Cl.: H05K 7/14, H05K 7/20

(54) **BAUKASTENSYSTEM ZUM HERSTELLEN EINES ELEKTRONIKGERÄTS**
MODULAR SYSTEM FOR PRODUCING AN ELECTRONIC DEVICE
SYSTÈME MODULAIRE POUR LA FABRICATION D'UN APPAREIL ÉLECTRONIQUE

(30) Priorität: 15.05.2018 BE 201805317
(43) Veröffentlichungstag der Anmeldung: 24.03.2021
(73) Patentinhaber: Phoenix Contact GmbH & Co. KG, 32825 Blomberg (DE)
(72) Erfinder: EUSTERHOLZ, Helmut, 33102 Paderborn (DE)
(86) Internationale Anmeldenummer: PCT/EP2019/062364
(87) Internationale Veröffentlichungsnummer: WO 2019/219695

(56) Entgegenhaltungen:
- EP-A1- 2 736 312
- EP-A2- 0 709 932
- US-A1- 2017 064 870

## Beschreibung

Die Erfindung betrifft ein Baukastensystem zum Herstellen eines Elektronikgeräts nach dem Oberbegriff des Anspruchs 1 sowie ein Verfahren zum Herstellen eines Elektronikgeräts unter Verwendung eines Baukastensystems.

Ein derartiges Baukastensystem zum Herstellen eines Elektronikgeräts umfasst ein Gehäuse, das einen Aufnahmeraum ausbildet, und eine Leiterplatte, die entlang einer Einschubrichtung in den Aufnahmeraum des Gehäuses einsetzbar und in einer Montagestellung in dem Aufnahmeraum aufgenommen ist.

Ein derartiges Elektronikgerät kann zusammen mit anderen Elektronikgeräten entlang einer Anreihrichtung kombiniert werden, sodass eine Mehrzahl von Elektronikgeräten entlang der Anreihrichtung aneinander angereiht sind. Das Elektronikgerät kann beispielsweise zusammen mit den anderen Elektronikgeräten an einer Tragschiene aufgenommen werden, sodass auf diese Weise eine elektrische Baugruppe geschaffen wird, die beispielsweise Steuer- oder Auswertefunktionen im Rahmen einer industriellen Anlage übernehmen kann.

Elektronische Bauteile sind hierbei auf der Leiterplatte angeordnet, die in das Gehäuse eingesetzt werden kann, um das Elektronikgerät auszubilden. Die Leiterplatte erstreckt sich in der Montagestellung zum Beispiel parallel zu Seitenwandungen des Gehäuses, zwischen denen der Aufnahmeraum gebildet ist, und ist in dem Gehäuse in geschützter Weise eingefasst.

Wünschenswert ist ein Elektronikgerät, das einfach, insbesondere zum Einsetzen und Fixieren der Leiterplatte in dem Gehäuse, montiert werden kann, dabei aber variabel auch in Abhängigkeit von der Ausgestaltung von elektronischen Bauteilen der Leiterplatte zum Beispiel mit Anschlüssen oder anderen Funktionskomponenten bestückbar ist. Hierbei ist zu berücksichtigen, dass gegebenenfalls für elektrische oder elektronische Bauelemente an der Leiterplatte eine Kühlung bereitgestellt werden muss, sodass im Betrieb entstehende Wärme aus dem Aufnahmeraum des Gehäuses in effizienter Weise abgeleitet werden kann und eine Überhitzung des Elektronikgeräts im Betrieb vermieden wird.

Bei einem aus der DE 44 28 687 C1 bekannten Elektronikgerät kann eine Leiterplatte zusammen mit einem an Bedienelementen der Leiterplatte vormontierten Gehäuseteil in ein Gehäuse eingesetzt werden. In montierter Stellung verschließt das Gehäuseteil eine Öffnung des Gehäuses.

Bei einem aus der EP 2 399 435 B1 bekannten Elektronikgerät werden Gehäuse mit Anschlusskammern an einer Leiterplatte vormontiert. Die Leiterplatte kann sodann zusammen mit Seitenteilen an einem Gehäusesockel angeordnet werden, um das Elektronikgerät zu komplettieren.

Aus der WO 2012/001084 A2 ist eine Abdeckung zum Einhausen eines Bereichs einer Leiterplatte bekannt, bei der an der Leiterplatte Kühlgitter zum Kühlen anzubringen sind, die in montierter Stellung einen Teil des Gehäuses ausbilden.

Aus der WO 2012/000808 A1 ist ein modulares System bekannt, bei dem Funktionsmodule an ein Gehäuse angesetzt werden können. Zwischen Elektronikgehäusen kann hierbei auch ein Kühlungsmodul angeordnet sein.

Weitere Dokumente zum Stand der Technik sind US2017064870, EP0709932 und EP2736312.

Aufgabe der vorliegenden Erfindung ist es, ein Baukastensystem sowie ein Verfahren zum Herstellen eines in Abhängigkeit von einer Anwendung konfigurierbaren Elektronikgeräts unter Verwendung eines Baukastensystems bereitzustellen, die eine einfache und somit kostengünstige Montage des Elektronikgeräts bei zudem effizienter Kühlung im Betrieb ermöglichen.

Diese Aufgabe wird durch einen Gegenstand mit den Merkmalen des Anspruchs 1 gelöst. Demnach umfasst das Baukastensystem zumindest ein Kühlelement, das eine erste Führungseinrichtung zur Führung an einer zweiten Führungseinrichtung des Gehäuses aufweist, wobei das zumindest eine Kühlelement derart mit der Leiterplatte verbindbar ist, dass bei Einsetzen der Leiterplatte in den Aufnahmeraum das zumindest eine Kühlelement über die erste Führungseinrichtung an der zweiten Führungseinrichtung des Gehäuses entlang der Einschubrichtung verschiebbar geführt ist.

An der Leiterplatte können somit ein oder mehrere Kühlelemente angeordnet werden, die zur Kühlung von elektrischen oder elektronischen Bauelementen der Leiterplatte dienen.

Das Kühlelement ist aus einem Material mit guten Wärmeleiteigenschaften gefertigt, zum Beispiel einem Kupfermaterial oder einem Aluminiummaterial. Über das Kühlelement kann somit eine günstige Wärmeableitung aus dem Aufnahmeraum des Gehäuses, insbesondere von im Betrieb Wärme erzeugenden Bauelementen des Elektronikgeräts, bereitgestellt werden.

Ein jedes Kühlelement weist hierbei (zumindest) eine erste Führungseinrichtung auf, über die die Kühlelemente an einer zugeordneten zweiten Führungseinrichtung des Gehäuses geführt werden, wenn die Leiterplatte zusammen mit den daran angeordneten Kühlelementen in den Aufnahmeraum des Gehäuses eingesetzt wird. Das Einsetzen der Leiterplatte in den Aufnahmeraum des Gehäuses erfolgt somit in einer über ein oder mehrere Kühlelemente geführten Weise. In der Montagestellung wird die Leiterplatte dann (auch) über die Kühlelemente in Position in dem Aufnahmeraum gehalten.

In einer Ausgestaltung weist das Gehäuse zwei entlang der Anreihrichtung zueinander beabstandete, zwischen sich einen Aufnahmeraum ausbildende Seitenwandungen auf. Die Einschubrichtung ist quer zur Anreihrichtung gerichtet. In der Montagestellung ist die Leiterplatte senkrecht zur Anreihrichtung erstreckt und somit parallel zu den Seitenwandungen ausgerichtet und in dieser Weise in dem Aufnahmeraum zwischen den Seitenwandungen aufgenommen.

Zur Herstellung des Elektronikgeräts können ein oder mehrere Kühlelemente mit der Leiterplatte verbunden und somit an der Leiterplatte vormontiert werden. Die Verbindung kann beispielsweise in kraftschlüssiger Weise über Befestigungselemente wie zum Beispiel Schrauben erfolgen, sodass in einer Vormontagestellung ein oder mehrere Kühlelemente an der Leiterplatte festgelegt sind. Das Ansetzen dieser vormontierten Baueinheit erfolgt in geführter Weise dadurch, dass erste Führungseinrichtungen eines oder mehrerer Kühlelemente mit zweiten Führungseinrichtungen zum Beispiel an den Seitenwandungen des Gehäuses in Eingriff gebracht werden, sodass die Baueinheit, also ein oder mehrere Kühlelemente zusammen mit der Leiterplatte, in das Gehäuse eingeschoben werden kann und die Leiterplatte in eine definierte Lage innerhalb des Aufnahmeraums gelangt. Jedes Kühlelement kann hierbei zwei parallel zueinander entlang der Einschubrichtung erstreckte, erste Führungseinrichtungen aufweisen, während die Seitenwandungen jeweils eine entlang der Einschubrichtung erstreckte, zweite Führungseinrichtung aufweisen.

In der Montagestellung fixiert das zumindest eine Kühlelement die Leiterplatte dann in dem Aufnahmeraum, indem die Leiterplatte über das zumindest eine Kühlelement mit den Seitenwandungen verbunden ist. Das zumindest eine Kühlelement erstreckt sich hierbei zwischen den Seitenwandungen und verbindet die Seitenwandungen formschlüssig miteinander, sodass das Gehäuse komplettiert ist.

Zur Montage können die ersten Führungseinrichtungen des an der Leiterplatte angeordneten zumindest einen Kühlelements und die zweiten Führungseinrichtungen der Seitenwandungen des Gehäuses vorzugsweise derart miteinander in Eingriff gebracht werden, dass das zumindest eine Kühlelement in einer senkrecht zur Einschubrichtung erstreckten Ebene fest mit den Seitenwandungen verbunden sind, entlang der Einschubrichtung aber zu den Seitenwandungen verschiebbar sind, bis die Montagestellung erreicht ist und die Leiterplatte zum Beispiel zusätzlich in der erreichten Endposition im Gehäuse verrastet. Das zumindest eine Kühlelement ist somit in der senkrecht zu Einschubrichtung erstreckten Ebene zu den Seitenwandungen festgelegt, also so mit den Seitenwandungen verbunden, dass eine feste Verbindung zwischen dem zumindest einen Kühlelement und den Seitenwandungen besteht, das zumindest eine Kühlelement jedoch entlang der Einschubrichtung zu den Seitenwandungen verschiebbar ist, bis die Montagestellung erreicht ist. Durch den Eingriff der ersten Führungseinrichtungen mit den zweiten Führungseinrichtungen wird somit eine Führung für das an der Leiterplatte angeordnete zumindest eine Kühlelement an den Seitenwandungen geschaffen, aufgrund derer das zumindest eine Kühlelement und darüber die Leiterplatte in definierter Weise zu den Seitenwandungen verschiebbar sind, ohne dass sich das zumindest eine Kühlelement dabei ohne weiteres aus ihrem geführten Eingriff mit den Seitenwandungen lösen kann.

Die Führung des zumindest einen Kühlelements an den Seitenwandungen kann beispielsweise dadurch bereitgestellt werden, dass jede erste Führungseinrichtung formschlüssig mit einer zugeordneten zweiten Führungseinrichtung in Eingriff bringbar ist, indem ein Eingriff eines Stegs in eine Nut hergestellt wird im Sinne einer Nut-und-Feder-Verbindung. Eine der Führungseinrichtungen weist somit einen Steg auf, die in eine zugeordnete Nut der anderen Führungseinrichtung eingreift und dadurch eine Führung entlang der Einschubrichtung bereitstellt, gleichzeitig aber das zumindest eine Kühlelement und die Seitenwandungen in der Ebene senkrecht zur Einschubrichtung so miteinander verbindet, dass der Eingriff zwischen dem zumindest einen Kühlelement und den Seitenwandungen nicht ohne weiteres lösbar ist.

In einer konkreten Ausgestaltung weisen die zweiten Führungseinrichtungen der Seitenwandungen jeweils einen Steg auf, während die ersten Führungseinrichtungen des zumindest einen Kühlelements jeweils eine mit dem Steg in Eingriff bringbare Nut aufweisen. Das zumindest eine Kühlelement weist somit zwei parallele zueinander erstreckte, entlang der Anreihrichtung voneinander beabstandete Nuten auf, die mit jeweils einem Steg einer Seitenwandung in Eingriff gebracht werden können, sodass darüber das zumindest eine Kühlelement an beiden Seitenwandungen verschiebbar geführt ist, dabei aber eine nicht ohne weiteres lösbare Verbindung zwischen dem zumindest einen Kühlelement und den Seitenwandungen geschaffen wird, sodass das zumindest eine Kühlelement in einer senkrecht zur Einschubrichtung erstreckten Ebene zu den Seitenwandungen formschlüssig festgelegt ist.

In alternativer Ausgestaltung ist auch denkbar, dass die ersten Führungseinrichtungen des zumindest einen Kühlelements jeweils einen Steg und die zweiten Führungseinrichtungen der Seitenwandungen jeweils eine Nut, mit der ein Steg einer zugeordneten ersten Führungseinrichtung in Eingriff bringbar ist, aufweisen.

In anderer Ausgestaltung ist auch denkbar, dass das Führungssystem als ganze oder halbe Schwalbenschwanzführung mit schräggestelltem Nut-Steg-System ausgeführt ist.

Der Formschluss zwischen den Führungseinrichtungen ist insbesondere derart, dass das zumindest eine Kühlelement in einer senkrecht zur Einschubrichtung erstreckten Ebene zu den Seitenwandungen festgelegt sind und somit eine Verbindung zwischen dem zumindest einen Kühlelement und den Seitenwandungen geschaffen ist. Um hierbei zu verhindern, dass das zumindest eine Kühlelement entlang einer Querrichtung, die quer zur Anreihrichtung und quer zur Einschubrichtung erstreckt ist, außer Eingriff von einem zugeordneten Steg gelangen kann, kann im Bereich der Nut ein Blockiersteg angeordnet sein, der den Steg in der Nut blockiert und ein Herausrutschen des Stegs aus der Nut entlang der Querrichtung verhindert. Der Steg kann beispielsweise in eine entlang der Querrichtung weisende Eingriffsrichtung in die Nut eingreifen. Der Blockiersteg blockiert ein Herausgleiten des Stegs entgegen der Eingriffsrichtung aus der Nut und sichert somit den Eingriff des Stegs in die Nut.

Um das zumindest eine Kühlelement in einer senkrecht zur Einschubrichtung erstreckten Ebene fest (aber entlang der Einschubrichtung aber zu den Seitenwandungen bis in die Montagestellung verschiebbar) mit den Seitenwandungen zu verbinden, umgreift die Nut den Führungssteg vorzugsweise an vier Seiten. Stufen, die der Führungssteg mit der zugeordneten Seitenwandung bildet, sind hierbei in Anlage mit dem Blockiersteg und einem Begrenzungsabschnitt der Nut. Der Führungssteg wird somit formschlüssig in Eingriff mit der Nut gehalten und kann in einer Ebene senkrecht zur Einschubrichtung nicht aus der Nut herausbewegt werden.

In einer Ausgestaltung weist das zumindest eine Kühlelement einen Bodenabschnitt auf, über den das zumindest eine Kühlelement mit der Leiterplatte verbindbar ist. Der Bodenabschnitt kann hierbei flächig erstreckt und dabei parallel zur Leiterplatte ausgerichtet sein. Über den Bodenabschnitt kann das Kühlelement beispielsweise mittels Schraubverbindungen an der Leiterplatte festgelegt werden.

An dem Bodenabschnitt können hierbei ein oder mehrere elektrische oder elektronische Bauelemente angeordnet sein, die elektrisch mit der Leiterplatte verbunden und im Betrieb des Elektronikgeräts zu kühlen sind. Die Bauelemente können zum Beispiel an einer der Leiterplatte abgewandten Oberseite des Bodenabschnitts befestigt sein. Denkbar ist aber auch, dass die Bauelemente an einer der Leiterplatte zugewandten Unterseite des Bodenabschnitts angeordnet sind und sich in einer Zwischenlage zwischen dem Bodenabschnitt und der Leiterplatte befinden, dabei aber so mit dem Bodenabschnitt in Wirkverbindung stehen, dass eine Wärmeableitung von den Bauelementen in den Bodenabschnitt erfolgen kann.

Das Kühlelement kann an eine Kante der Leiterplatte anzusetzen sein und sich auf einer Seite zwischen den Seitenwandungen erstrecken. Denkbar und möglich ist aber auch, dass das Kühlelement sich entlang der Querrichtung durch den Aufnahmeraum von einer Seite des Gehäuses hin zur anderen Seite des Gehäuses über die Leiterplatte hinweg erstreckt.

Von dem Bodenabschnitt können beispielsweise eine oder mehrere Querwandungen vorstehen, die sich entlang einer senkrecht zur Einschubrichtung gerichteten Ebenen erstrecken. Ein oder mehrere elektrische oder elektronische Bauelemente, die elektrisch mit der Leiterplatte verbunden sind, können hierbei an einer oder an unterschiedlichen der Querwandungen angeordnet sein, sodass eine Wärmeeinleitung von den Bauelementen in das Kühlelement über die Querwandungen erfolgt.

Durch solche von dem Bodenabschnitt abstehenden Querwandungen kann beispielsweise ein Kühlelement mit einer U-Form (betrachtet im Querschnitt senkrecht zur Querrichtung) geschaffen werden.

Zwischen parallel zueinander erstreckten Querwandungen ist beispielsweise ein Strömungskanal gebildet, der sich vorzugsweise entlang der Querrichtung durch den Aufnahmeraum hindurch erstreckt und beispielsweise an den entlang der Querrichtung voneinander abliegenden Seite des Gehäuses geöffnet ist. Durch den Strömungskanal kann, zum Beispiel aufgrund von Konvektion bei bestimmungsgemäßer Einbaulage des Elektronikgeräts, ein Luftstrom entlang des Kühlelements durch den Aufnahmeraum strömen, sodass auf diese Weise Wärme zum Zwecke der Kühlung des Elektronikgeräts abgeleitet werden kann.

Der Luftstrom kann sich aufgrund von Konvektion ergeben. Denkbar und möglich ist aber auch, an dem Kühlelement zusätzlich eine Fördereinrichtung zum Beispiel in Form eines Ventilators anzubringen, um einen Luftstrom entlang des Kühlelements zu fördern.

In einer Ausgestaltung weist das Kühlelement Rippenabschnitte auf, die entlang der Querrichtung von dem Gehäuse vorstehen und somit die Oberfläche des Kühlelements vergrößern. Die Rippenabschnitte können beispielsweise an Querwandungen des Kühlelements geformt sein. Denkbar und möglich ist aber auch, dass die Rippenabschnitte von einem flächig erstreckten Wandungsabschnitt vorstehen, der flächig zwischen den Seitenwandungen entlang einer durch die Einschubrichtung und die Anreihrichtung aufgespannten Ebene erstreckt ist und das Gehäuse im Bereich zwischen den Seitenwandungen zumindest teilweise verschließt.

In einer Ausgestaltung weist das Baukastensystem - zusätzlich zu dem zumindest einen Kühlelement - eine Mehrzahl von mit der Leiterplatte verbindbaren Ansetzteilen auf, die jeweils, betrachtet entlang der Einschubrichtung, eine Teilung aufweisen, die einer vorbestimmten kleinsten Teilungseinheit oder einem ganzzahligen Vielfachen der vorbestimmten kleinsten Teilungseinheit entspricht. Jedes Ansetzteil weist hierbei vorzugsweise - wie das zumindest eine Kühlelement - eine erste Führungseinrichtung zur Führung an einer zweiten Führungseinrichtung des Gehäuses auf, wobei eine Kombination von Ansetzteilen zusammen mit dem zumindest einen Kühlelement entlang der Einschubrichtung aneinander angereiht mit der Leiterplatte derart verbindbar ist, dass bei Einsetzen der Leiterplatte in den Aufnahmeraum die Kombination von Ansetzteilen und das zumindest eine Kühlelement über ihre ersten Führungseinrichtungen an der zweiten Führungseinrichtung des Gehäuses entlang der Einschubrichtung verschiebbar geführt ist.

Im Rahmen des Baukastensystems sind somit mehrere unterschiedliche Ansetzteile und gegebenenfalls auch mehrere unterschiedliche Kühlelemente vorhanden, die variabel und in unterschiedlicher Weise miteinander kombiniert werden können. Dadurch, dass die Ansetzteile eine Teilung aufweisen, die einer vorbestimmten kleinsten Teilungseinheit oder einem ganzzahligen Vielfachen der vorbestimmten kleinsten Teilungseinheit entspricht, können grundsätzlich beliebige Kombinationen von Ansetzteilen derart entlang der Einschubrichtung aneinander angereiht werden, dass sich eine Kombination von Ansetzteilen mit einer vorbestimmten Gesamtlänge ergibt, entsprechend zum Beispiel der Länge einer Gehäuseöffnung (gemessen entlang der Einschubrichtung), die durch die Ansetzteile zu verschließen ist. Eine Leiterplatte kann somit mit ganz unterschiedlichen Kombinationen von Ansetzteilen bestückt werden, um zusammen mit den Ansetzteilen in den Aufnahmeraum des Gehäuses eingesetzt zu werden und somit das Elektronikgerät auszubilden.

Mehrere Ansetzteilen können miteinander und mit einem oder mit mehreren unterschiedlichen Kühlelementen kombiniert und zur Herstellung des Elektronikgeräts an der Leiterplatte vormontiert werden, um die Leiterplatte zusammen mit den daran angeordneten Ansetzteilen und Kühlelementen in das Gehäuse einzusetzen. In der Vormontagestellung sind die Ansetzteile stoffschlüssig (zum Beispiel mittels Löten), kraftschlüssig oder formschlüssig mit der Leiterplatte verbunden und bilden somit zusammen mit der Leiterplatte eine vormontierte Baueinheit, die an das Gehäuse des Elektronikgeräts angesetzt werden kann.

Durch die Verwendung unterschiedlicher Ansetzteile in Kombination miteinander können unterschiedliche Funktionen an der Leiterplatte bereitgestellt werden. Es ergibt sich somit ein flexibel verwendbares Baukastensystem, mittels dessen ganz unterschiedliche Elektronikgeräte in variabler Weise hergestellt und anwendungsbezogen konfiguriert werden können. Die Ansetzteile können hierbei insbesondere eine Geräteschnittstelle von der Leiterplattenbaustufe des hergestellten Elektronikgeräts nach Außen bereitstellen.

Auch das zumindest eine Kühlelement weist, betrachtet entlang der Einschubrichtung, vorzugsweise eine Teilung auf, die der vorbestimmten kleinsten Teilungseinheit oder einem ganzzahligen Vielfachen der vorbestimmten kleinsten Teilungseinheit entspricht. Ein oder mehrere Kühlelemente können somit in variabler Weise mit einem oder mehreren Ansetzteilen kombiniert werden und in Kombination an die Leiterplatte und darüber an dem Gehäuse angeordnet werden.

Die vorbestimmte kleinste Teilungseinheit (kurz: TE; englisch: Unit) definiert eine Grundlänge entlang der Einschubrichtung. Einige Ansetzteile und/oder Kühlelemente können beispielsweise eine Teilung entsprechend der einfachen Teilungseinheit aufweisen. Andere Ansetzteile und/oder Kühlelemente können eine Teilung entsprechend der doppelten Teilungseinheit aufweisen, also doppelt so lang wie die Teilungseinheit sein. Wiederum andere Ansetzteile und/oder Kühlelemente können beispielsweise eine Teilung entsprechend dem Dreifachen der Teilungseinheit aufweisen. Unterschiedliche Ansetzteile können somit entlang der Einschubrichtung miteinander kombiniert werden, um eine Kombination von Ansetzteilen und/oder Kühlelementen mit einer vorbestimmten Länge zu schaffen. Weist beispielsweise eine Gehäuseöffnung, in die die Kombination von Ansetzteilen und/oder Kühlelementen einzuschieben ist, eine Länge entsprechend der fünffachen Teilungseinheit auf, so können Ansetzteile und/oder Kühlelemente derart miteinander kombiniert werden, dass sich die Gesamtlänge entsprechend der fünffachen Teilungseinheit ergibt.

In einer Ausgestaltung sind die Ansetzteile in der Montagestellung entlang der Anreihrichtung zwischen den Seitenwandungen erstreckt. Die Ansetzteile der an die Leiterplatte angesetzten Kombination von Ansetzteilen können sich beispielsweise flächig entlang der Anreihrichtung und der Einschubrichtung erstrecken und können beispielsweise eine Begrenzung des Aufnahmeraums nach außen hin bereitstellen, sodass die Ansetzteile das Gehäuse komplettieren und zusammen mit anderen Gehäuseabschnitten den Aufnahmeraum des Gehäuses nach außen hin abschließen.

Die Ansetzteile können beispielsweise, betrachtet in einer durch die Anreihrichtung und die Einschubrichtung aufgespannten Ebene, jeweils einen Körper aufweisen, der ein Flächenelement bereitstellt, das betrachtet entlang der Einschubrichtung die Teilung des jeweiligen Ansetzteils definiert. Der Körper kann beispielsweise eine rechteckige Grundform (in einer durch die Anreihrichtung und die Einschubrichtung aufgespannten Ebene) aufweisen, mit einer Teilung, die der Teilungseinheit oder einem ganzzahligen Vielfachen der Teilungseinheit entspricht. Mehrere Ansetzteile können entlang der Einschubrichtung aneinander angereiht und aneinander anschließend an der Leiterplatte angeordnet werden, sodass die Leiterplatte in modularer Weise mit unterschiedlichen Kombinationen von Ansetzteilen bestückt werden kann.

In einer Ausgestaltung weist die Leiterplatte entlang der Einschubrichtung erstreckte, einander gegenüberliegende Seitenkanten auf, an denen die Ansetzteile und/oder Kühlelemente anzuordnen sind. Eine gewünschte Kombination von Ansetzteilen und/oder Kühlelementen wird somit an den Seitenkanten der Leiterplatte aneinander angereiht und miteinander und mit einem oder mehreren Kühlelementen kombiniert, sodass die Ansetzteile und die Kühlelemente in einem mit der Leiterplatte verbundenen Zustand sich entlang der Seitenkanten der Leiterplatte erstrecken.

Zur Montage der Leiterplatte in dem Gehäuse wird die Leiterplatte mit einer Kombination von Ansetzteilen und Kühlelementen bestückt und zusammen mit den Ansetzteilen und Kühlelementen in das Gehäuse eingesetzt. Hierbei kann vorzugsweise vorgesehen sein, dass die Leiterplatte in der Montagestellung (ausschließlich) über die Ansetzteile und die Kühlelemente in dem Aufnahmeraum des Gehäuses fixiert ist, sodass eine Verbindung zwischen der Leiterplatte und dem Gehäuse (nur) mittelbar über die Ansetzteile und die Kühlelemente geschaffen wird.

Die Ansetzteile können ganz unterschiedliche Funktionen übernehmen und hierzu ganz unterschiedlich ausgestaltet sein.

So kann ein Ansetzteil beispielsweise ein Blendenteil für einen mit der Leiterplatte (elektrisch) verbundenen elektrischen Anschluss bereitstellen. Hierzu kann das Ansetzteil beispielsweise eine Öffnung aufweisen über die ein Steckverbinderteil mit dem elektrischen Anschluss verbunden werden kann.

In anderer Ausgestaltung kann das Ansetzteil beispielsweise eine Klemmeneinrichtung verwirklichen, die ein oder mehrere Stecköffnungen aufweist, in die elektrische Leiter (zum Beispiel mit abisolierten Leitungsenden) oder optische Leiter (Lichtwellenleiter) zum Zwecke der elektrischen oder optischen Kontaktierung eingesteckt werden können. Eine solche Klemmeneinrichtung kann beispielsweise als Federkraftklemme oder dergleichen verwirklicht sein. Unterschiedliche Klemmeneinrichtungen können hierbei Stecköffnungen zum Einstecken unterschiedlicher elektrischer Leiter mit unterschiedlichem Leitungsquerschnitt aufweisen. Klemmeneinrichtungen verschiedener Poldichte (also einer der Anschlusszahl entsprechenden Polzahl pro Teilungseinheit) zum Anschließen unterschiedlicher Leiter können somit miteinander kombiniert und an der Leiterplatte angeordnet werden.

Denkbar und möglich ist aber auch, dass ein Ansetzteil ein flächiges Wandungselement (ohne weitere elektrische Funktion) zum Verschließen des Gehäuses nach außen verwirklicht. Ein solches flächiges Wandungselement kann beispielsweise einen Abschluss das Gehäuse bereitstellen. Ein solches flächiges Wandungselement kann dabei auch als sogenannter Spacer dienen, um eine räumliche Separierung zwischen elektrischen Bauelementen, zum Beispiel zwischen elektrischen Anschlüssen, bereitzustellen und eine elektrische Wechselwirkung zwischen den elektrischen Bauelementen zu verhindern (im Sinne einer Vergrößerung einer Kriechstrecke).

In wiederum anderer Ausgestaltung kann das Ansetzteil auch ein Gitterelement bereitstellen, über das zum Beispiel eine Kühlung für eine in dem Aufnahmeraum eingefasste elektronische Baugruppe bereitgestellt werden kann.

Die Ansetzteile können auch Bedienelemente wie zum Beispiel Schalter (zum Beispiel DIP-Schalter), Regler (zum Beispiel für ein Potentiometer), Anzeigen zum Beispiel in Form von Leuchtdioden oder Displays, eine elektrische Sicherung oder auch mechanische oder elektrische Funktionselemente zum Beispiel in Form eines Schraubanschluss zur Befestigung des Gehäuses an einer anderen Baugruppe, zum Beispiel innerhalb eines Schaltschranks, oder auch in Form einer Schirmungsauflage zum Herstellen einer elektromagnetischen Schirmung oder einer Zugentlastung für ein daran festzulegendes Kabel bereitstellen.

Unterschiedliche Ansetzteile können hierbei eine unterschiedliche Farbgebung aufweisen, welche eine elektrotechnische Funktion signalisieren (wie z.B. L/N/PE, EXi, +/-, Signalart, Safety oder dergleichen, die üblicherweise durch eine spezifische Farbkennzeichnung angezeigt werden). Dies hat den technischen Vorteil, dass eine nachträgliche lokale Bedruckung des Gehäuses, wie bei herkömmlichen Elektronikgeräten, entfallen kann. Soll ein Gehäuse eines Elektronikgeräts abschnittsweise eine bestimmte Farbgebung oder Markierung aufweisen, so kann ein entsprechendes Ansetzteil verwendet und an das Gehäuse angesetzt werden, um somit eine gewünschte Farbgebung oder Markierung bereitzustellen.

Das Elektronikgerät kann vorzugsweise mit anderen Elektronikgeräten kombiniert werden, indem die Elektronikgeräte entlang der Anreihrichtung aneinander angereiht und zum Beispiel an einer Tragschiene befestigt werden. Das Elektronikgerät kann hierzu eine Befestigungseinrichtung, zum Beispiel in Form einer Rasteinrichtung, aufweisen, über die das Elektronikgerät an der Tragschiene festgelegt werden kann.

Die Aufgabe wird auch gelöst durch ein Verfahren zum Herstellen eines entlang einer Anreihrichtung mit anderen Elektronikgehäusen anreihbaren Elektronikgeräts unter Verwendung eines Baukastensystems, bei dem eine Leiterplatte entlang einer Einschubrichtung in einen Aufnahmeraum eines Gehäuses eingesetzt wird und in einer Montagestellung in dem Aufnahmeraum aufgenommen ist. Zum Herstellen des Elektronikgeräts wird zumindest ein Kühlelement, das eine erste Führungseinrichtung zur Führung an einer zweiten Führungseinrichtung des Gehäuses aufweist, mit der Leiterplatte verbunden, und bei Einsetzen der Leiterplatte in den Aufnahmeraum wird das zumindest eine Kühlelement über die erste Führungseinrichtung an der zweiten Führungseinrichtung des Gehäuses entlang der Einschubrichtung verschiebbar geführt.

Die vorangehend für das Elektronikgerät beschriebenen Vorteile und vorteilhaften Ausgestaltungen finden analog auch auf das Verfahren Anwendung, sodass diesbezüglich auf das vorangehend Ausgeführte verwiesen werden soll.

Der der Erfindung zugrunde liegende Gedanke soll nachfolgend anhand der in den Figuren dargestellten Ausführungsbeispiele näher erläutert werden. Es zeigen:
- Fig. 1: eine perspektivische Ansicht eines Ausführungsbeispiels eines Elektronikgeräts;
- Fig. 2: eine Ansicht des Elektronikgeräts bei der Montage;
- Fig. 3: eine Ansicht eines Kühlelements zusammen mit Ansetzteilen an einer Leiterplatte des Elektronikgeräts;
- Fig. 4: eine Schnittansicht durch das Kühlelement;
- Fig. 5: eine perspektivische Ansicht eines weiteren Ausführungsbeispiels eines Elektronikgeräts;
- Fig. 6: eine Ansicht bei der Montage des Elektronikgeräts;
- Fig. 7: eine vergrößerte Schnittansicht eines Kühlelements an der Leiterplatte des Elektronikgeräts;
- Fig. 8: eine perspektivische Ansicht eines weiteren Ausführungsbeispiels eines Elektronikgeräts;
- Fig. 9: eine Ansicht des Elektronikgeräts bei der Montage;
- Fig. 10: eine perspektivische Ansicht eines wiederum anderen Ausführungsbeispiels eines Elektronikgeräts;
- Fig. 11: eine Ansicht des Elektronikgeräts bei der Montage;
- Fig. 12: die Ansicht gemäß Fig. 11, bei von der Leiterplatte abgenommenem Kühlelement; und
- Fig. 13: eine schematische Ansicht einer ersten Führungseinrichtung eines Kühlelements in Zusammenwirken mit einer zweiten Führungseinrichtung an einer Seitenwandung des Gehäuses.

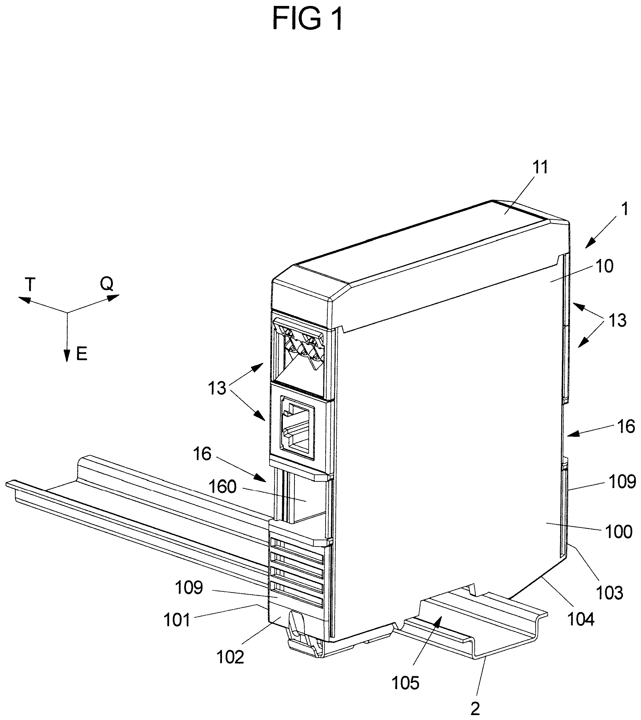

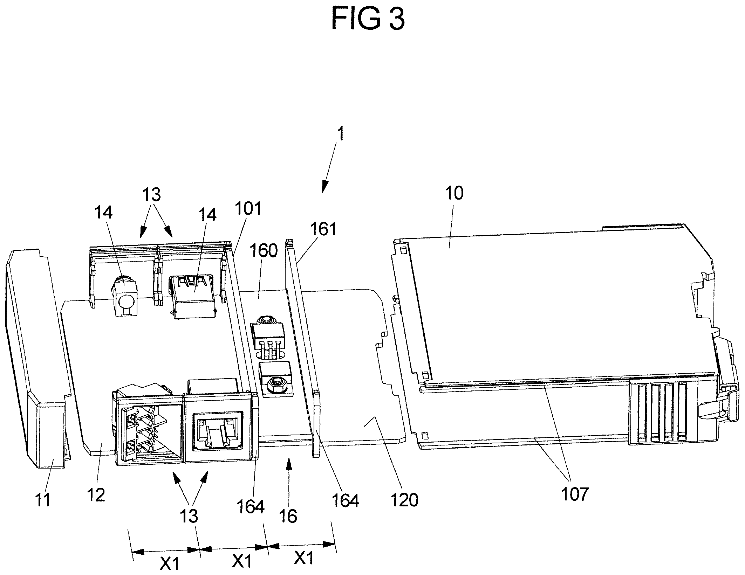

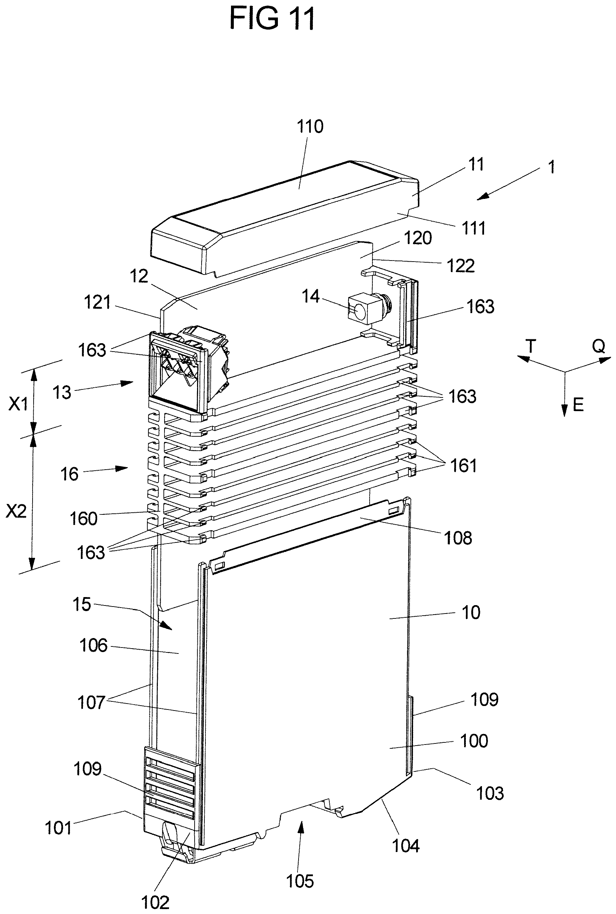

Fig. 1 bis 4, Fig. 5 bis 7, Fig. 8 und 9 und Fig. 10 bis 12 zeigen unterschiedliche Ausführungsbeispiele eines unter Verwendung eines Baukastensystems hergestellten Elektronikgeräts 1, das jeweils ein Gehäuse 10 und eine in dem Gehäuse 10 eingefasste elektronische Baugruppe in Form einer Leiterplatte und daran angeordneten Elektronikkomponenten aufweist. Das Elektronikgerät 1 kann über eine Befestigungseinrichtung 105 an einer Unterseite 104 des Gehäuses 10 an eine Tragschiene 2 angesetzt und dabei entlang einer Anreihrichtung T in aneinander angereihter Weise mit anderen Elektronikgeräten 1 kombiniert werden.

Bei dem Baukastensystem der dargestellten Ausführungsbeispiele weist das Gehäuse 10 zwei senkrecht zur Anreihrichtung T erstreckte, entlang der Anreihrichtung T zueinander beabstandete Seitenwandungen 100, 101 sowie Stirnseiten 102, 103 auf, die das im wesentlichen quaderförmige Gehäuse 10 definieren. Die Seitenwandungen 100, 101 sind flächig erstreckt derart, dass andere Elektronikgeräte 1 beidseits an das Elektronikgerät 1 angesetzt und mit dem Elektronikgerät 1 an einer Tragschiene 2 kombiniert werden können.

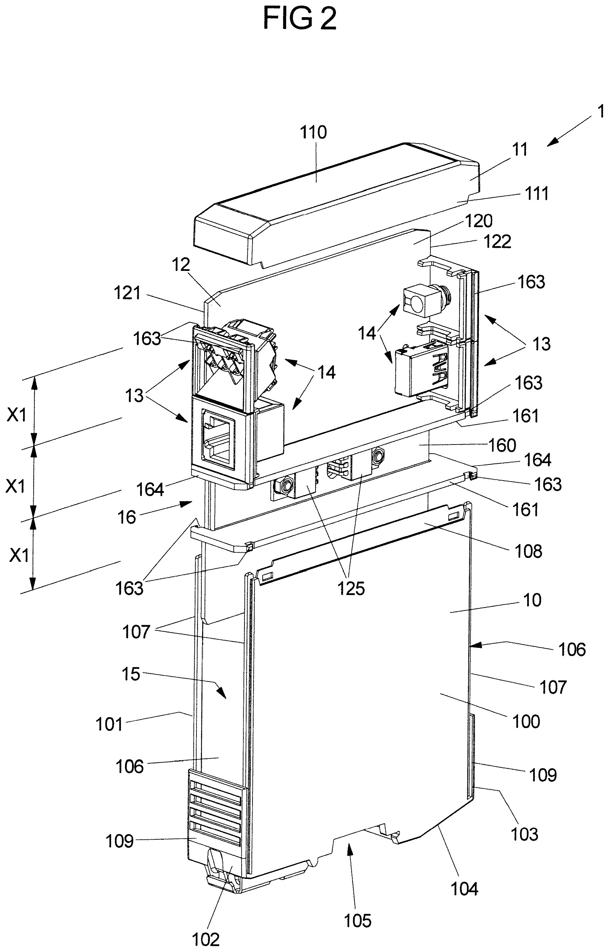

Wie dies zum Beispiel aus Fig. 2 ersichtlich ist, bilden die Seitenwandungen 100, 101 zwischen sich einen Aufnahmeraum 15, in den eine Leiterplatte 12 in eine Einschubrichtung E eingesetzt werden kann derart, dass in einer Montagestellung die Leiterplatte 12 in dem Aufnahmeraum 15 aufgenommen und dabei parallel zu den Seitenwandungen 100, 101 erstreckt ist. An der Leiterplatte 12 können unterschiedliche Elektronikkomponenten, zum Beispiel Elektronikbausteine in Form von elektronischen Schaltkreisen, angeordnet sein, die eine Elektronikbaugruppe des Elektronikgeräts 1 ausbilden.

Bei den dargestellten Ausführungsbeispielen sind an der Leiterplatte 12 ein oder mehrere Kühlelemente 16 zusammen mit Ansetzteilen 13 angeordnet, die zusammen mit der Leiterplatte 12 an dem Gehäuse 10 montiert werden. Die Ansetzteile 13 werden an entlang der Einschubrichtung E erstreckten Seitenkanten 121, 122 der Leiterplatte 12 angeordnet und stehen in verbundener Stellung entlang der Anreihrichtung T von einer Oberfläche 120 der Leiterplatte 12 vor.

Die Ausführungsbeispiele gemäß Fig. 1 bis 4, Fig. 5 bis 7, Fig. 8 und 9 und Fig. 10 bis 12 sind unter Verwendung desselben Baukastensystems hergestellt und unterscheiden sich insbesondere in der Kombination der verwendeten Kühlelemente 16 und Ansetzteile 13. Im Rahmen des Baukastensystems wird eine Kombination von aus einer Vielzahl von unterschiedlichen Kühlelementen 16 und Ansetzteilen 13 ausgewählten Kühlelementen 16 und Ansetzteilen 13 an der Leiterplatte 12 angeordnet, und die Leiterplatte 12 wird mit daran angeordneten Kühlelementen 16 und Ansetzteilen 13 in das Gehäuse 10 eingesetzt, um insbesondere eine gewünschte elektrische Funktionalität für das Elektronikgerät 1 zur Verfügung zu stellen.

Wie dies aus den unterschiedlichen Ausführungsbeispielen gemäß Fig. 1 bis 4, Fig. 5 bis 7, Fig. 8 und 9 und Fig. 10 bis 12 ersichtlich ist, können ganz unterschiedliche Kühlelemente 16 und Ansetzteile 13 vorliegen und ein Baukastensystem ausbilden, aus dem ausgewählt werden kann, um die Leiterplatte 12 in variabler Weise zu bestücken und um an dem Elektronikgerät 1 ganz unterschiedliche Funktionalitäten bereitzustellen. Die Kühlelemente 16 und die Ansetzteile 13 weisen jeweils, betrachtet entlang der Einschubrichtung E, eine Teilung X1, X2 auf, die einer vorbestimmten kleinsten Teilungseinheit X1 oder einem ganzzahligen Vielfachen dieser vorbestimmten kleinsten Teilungseinheit X1 entspricht. Dies ermöglicht, unterschiedliche Kühlelemente 16 und Ansetzteile 13 miteinander zu kombinieren, um eine gewünschte elektrische und/oder mechanische Funktion an der Leiterplatte 12 und dem Elektronikgerät 1 zur Verfügung zu stellen.

Wie zum Beispiel aus Fig. 2 ersichtlich, weist das Gehäuse 10 bei den dargestellten Ausführungsbeispielen an jeder Stirnseite 102, 103 je eine Gehäuseöffnung 106 auf, die bei diesem Ausführungsbeispiel eine funktional verwendbare Länge (gemessen entlang der Einschubrichtung E) des Dreifachen der kleinsten Teilungseinheit X1 aufweist. Entsprechend können in jeder Gehäuseöffnung 106 zum Beispiel gerade drei Ansetzteile 13 und/oder Kühlelemente 16 mit einer Teilung entsprechend der einfachen Teilungseinheit X1 angeordnet werden, wie dies aus Fig. 1 und 2 ersichtlich ist.

Die Ansetzteile 13 bilden beispielsweise Blendenteile für Anschlusseinrichtungen 14 der Leiterplatte 12 oder Klemmeneinrichtungen zum Anschließen elektrischer Leiter aus und werden vor dem Einsetzen der Leiterplatte 12 in den Aufnahmeraum 15 des Gehäuses 10 zusammen mit einem oder mehreren Kühlelementen 16 mit der Leiterplatte 12 verbunden, sodass eine vormontierte Baueinheit der Leiterplatte 12 mit den daran angeordneten Ansetzteilen 13 und Kühlelementen 16 geschaffen wird. Die so geschaffene vormontierte Baueinheit kann sodann in die Einschubrichtung E an dem Gehäuse 10 montiert werden, indem die Ansetzteile 13 und Kühlelemente 16 an die Seitenwandungen 100, 101 des Gehäuses 10 angesetzt und in die Einschubrichtung E auf die Seitenwandungen 100, 101 aufgeschoben werden.

Die Ausführungsbeispiele gemäß Fig. 1 bis 4, Fig. 5 bis 7, Fig. 8 und 9 und Fig. 10 bis 12 unterscheiden sich durch die Ausgestaltung der Kühlelemente 16 und der Ansetzteile 13, sind mit Blick auf das Gehäuse 10 jedoch identisch.

Bei dem Ausführungsbeispiel gemäß Fig. 1 bis 4 ist ein Kühlelement 16 an der Leiterplatte 12 befestigt, das sich entlang der Querrichtung Q über die gesamte Leiterplatte 12 hinweg erstreckt, im Querschnitt quer zur Querrichtung Q eine U-Form aufweist und mit einem Bodenabschnitt 160 flächig an die Leiterplatte 12 angesetzt ist derart, dass der Bodenabschnitt 160 mit einer Oberseite 120 der Leiterplatte 12 in flächiger Anlage ist. Von dem Bodenabschnitt 160 erstrecken sich Querwandungen 161, die Schenkel der U-Form bilden und parallel zueinander (bei montiertem Elektronikgerät 1) durch den Aufnahmeraum 15 des Gehäuses 10 hindurch erstreckt sind. Zwischen den Querwandungen 161 wird somit ein Strömungskanal geschaffen, durch den hindurch ein Luftstrom strömen kann, um Wärme aus dem Bereich des Aufnahmeraums 15 abzuleiten.

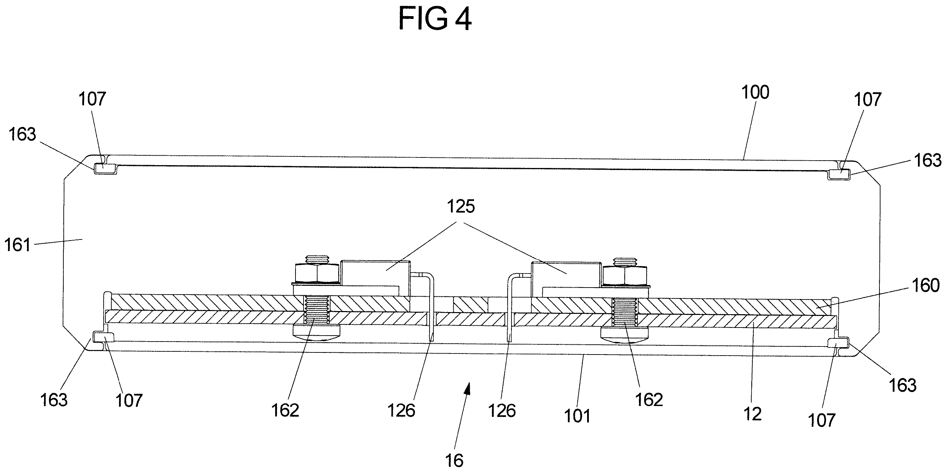

Bei dem in Fig. 1 bis 4 dargestellten Ausführungsbeispiel sind an dem Bodenabschnitt 160 an einer der Leiterplatte 12 abgewandten Seite elektronische Bauelemente 125 angeordnet, die über elektrische Anschlussarme 126 elektrisch mit der Leiterplatte 12 verbunden sind, wie dies zum Beispiel aus Fig. 4 ersichtlich ist. Die Bauelemente 125 sind über Befestigungseinrichtungen 162 in Form von Schrauben, über die das Kühlelement 16 mit der Leiterplatte 12 fest verbunden ist, an dem Bodenabschnitt 160 festgelegt.

Bei dem Ausführungsbeispiel gemäß Fig. 1 bis 4 weist das Kühlelement 16, betrachtet entlang der Einschubrichtung E, eine Teilung auf, die der kleinsten Teilungseinheit X1 entspricht. Mit dem Kühlelement 16 sind Ansetzteile 13 kombiniert, die beidseitig an den Seitenkanten 121, 122 der Leiterplatte 12 angesetzt sind und ebenfalls eine Teilung entsprechend der kleinsten Teilungseinheit X1 aufweisen.

Bei dem dargestellten Ausführungsbeispiel stehen die Querwandungen 161 mit Rippenabschnitten 164 beidseitig entlang der Querrichtung Q von dem Gehäuse 10 nach außen hin vor, sodass die Oberfläche der Querwandungen 161 nach außen hin vergrößert ist.

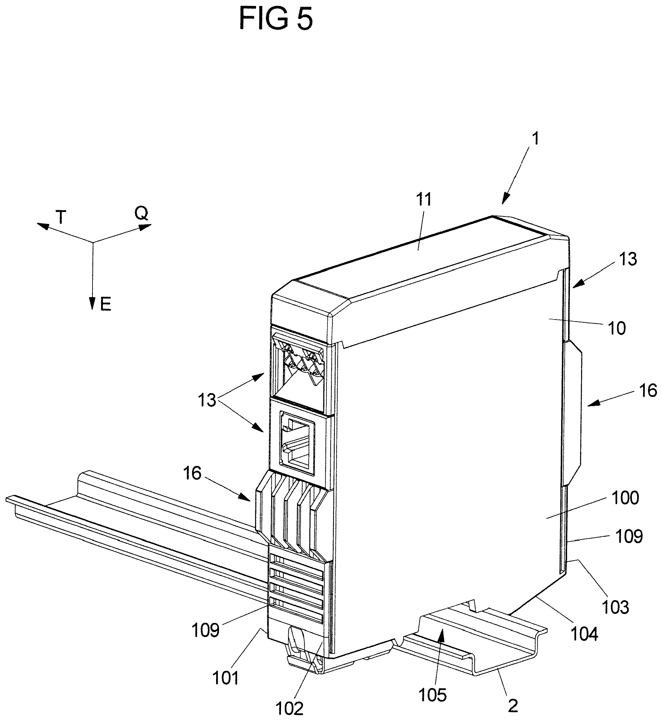

Bei dem Ausführungsbeispiel gemäß Fig. 5 bis 7 sind demgegenüber Kühlelemente 16 beidseitig an die Seitenkanten 121, 122 der Leiterplatte 12 angesetzt. Jedes Kühlelement 16 weist eine L-Form auf, mit einem Bodenabschnitt 160, über den das Kühlelement 16 mit der Leiterplatte 12 verbunden ist, und einem Wandungsabschnitt 165, der senkrecht zur Querrichtung Q erstreckt ist und das Gehäuse 10 an den Öffnungen 106 abschnittsweise abschließt.

Von den Wandungsabschnitten 165 stehen Rippenabschnitte 164 nach außen hin vor, wobei mehrere parallel zueinander erstreckte, entlang der Anreihrichtung T zueinander beabstandete Rippenabschnitte 164 an jedem Wandungsabschnitt 165 geformt sind.

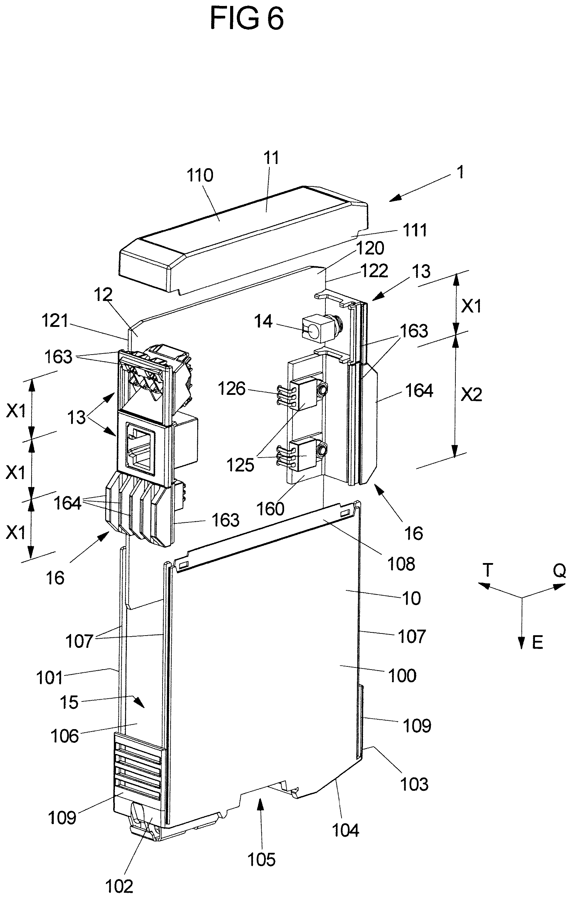

Bei diesem Ausführungsbeispiel weist das in Fig. 6 links dargestellte Kühlelement 16 eine Teilung auf, die der kleinsten Teilungseinheit X1 entspricht. Das in Fig. 6 rechts dargestellte Kühlelement 16 weist demgegenüber die doppelte Teilung X2, entsprechend dem zweifachen der kleinsten Teilungseinheit X1, auf.

Elektronische Bauelemente 125 sind an den Bodenabschnitten 160 der Kühlelemente 16 befestigt, sodass über die Bodenabschnitte 160 eine Wärmeeinleitung in die Kühlelemente 16 erfolgt. Wiederum sind die Bauelemente 125 über Befestigungseinrichtungen 162 in Form von Schrauben, über die die Kühlelemente 16 auch an der Leiterplatte 12 festgelegt sind, an den Bodenabschnitten 160 fixiert.

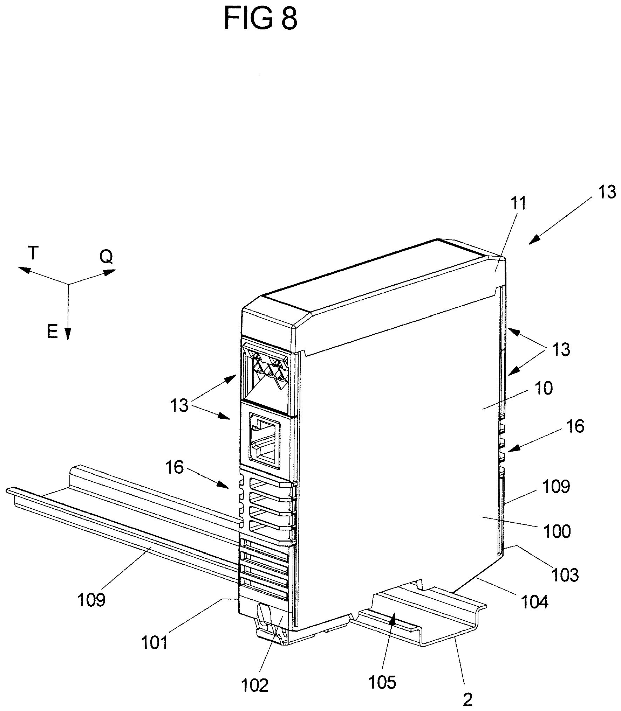

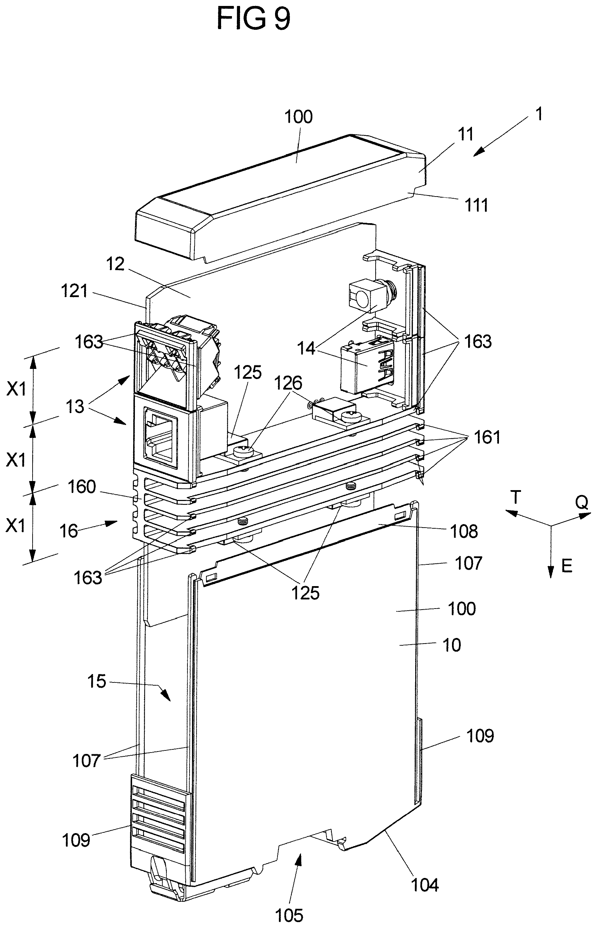

Bei dem Ausführungsbeispiel gemäß Fig. 8 und 9 ist ein Kühlelement 16 an der Leiterplatte 12 angeordnet, das sich entlang der Querrichtung Q über die gesamte Leiterplatte 12 hinweg erstreckt. Das Kühlelement 16 weist einen Bodenabschnitt 160 sowie mehrere (bei dem dargestellten Ausführungsbeispiel fünf) parallel zueinander erstreckte Querwandungen 161 auf, die entlang der Einschubrichtung E zueinander beabstandet sind und zwischen sich Strömungskanäle für einen Luftstrom durch das Kühlelement 16 entlang der Querrichtung Q bilden.

Das Kühlelement 16 ist mit einem Bodenabschnitt 160 an die Oberseite 120 der Leiterplatte 12 angesetzt. Elektronische Bauelemente 125 sind hierbei über Befestigungseinrichtungen 126 in Form von Schrauben an den Außenseiten der äußeren Querwandungen 161 fixiert, wie dies aus Fig. 9 ersichtlich ist.

Das Kühlelement 16 des Ausführungsbeispiels gemäß Fig. 8 und 9 weist eine Teilung auf, die der kleinsten Teilungseinheit X1 entspricht.

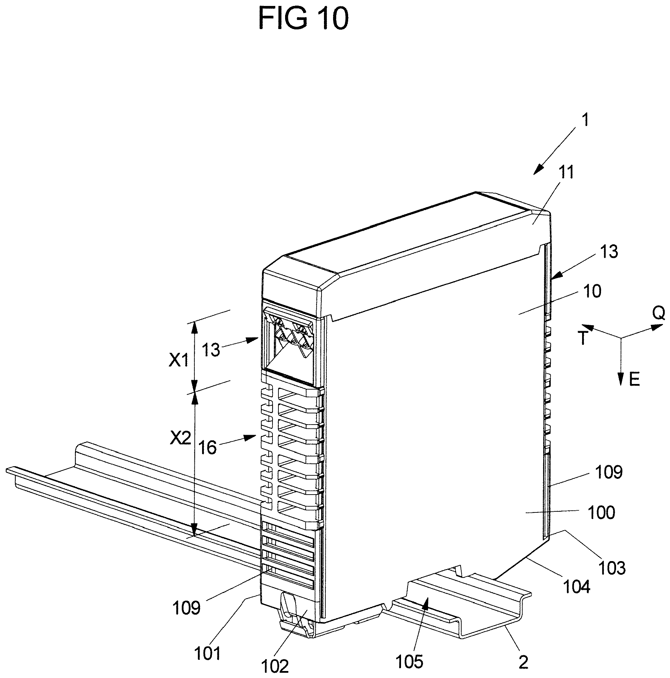

Bei dem Ausführungsbeispiel gemäß Fig. 10 bis 12 ist ein Kühlelement 16 mit der Leiterplatte 12 verbunden, das sich entlang der Querrichtung Q über die gesamte Leiterplatte 12 hinweg erstreckt und dabei eine Teilung X2 aufweist, die dem zweifachen der kleinsten Teilungseinheit X1 entspricht. Das Kühlelement 16 weist einen Bodenabschnitt 160 auf, von dem parallel zueinander erstreckte, entlang der Einschubrichtung E zueinander beabstandete Querwandungen 161 vorstehen und zwischen sich Strömungskanäle für einen Luftstrom entlang der Querrichtung Q an dem Kühlelement 16 ausbilden.

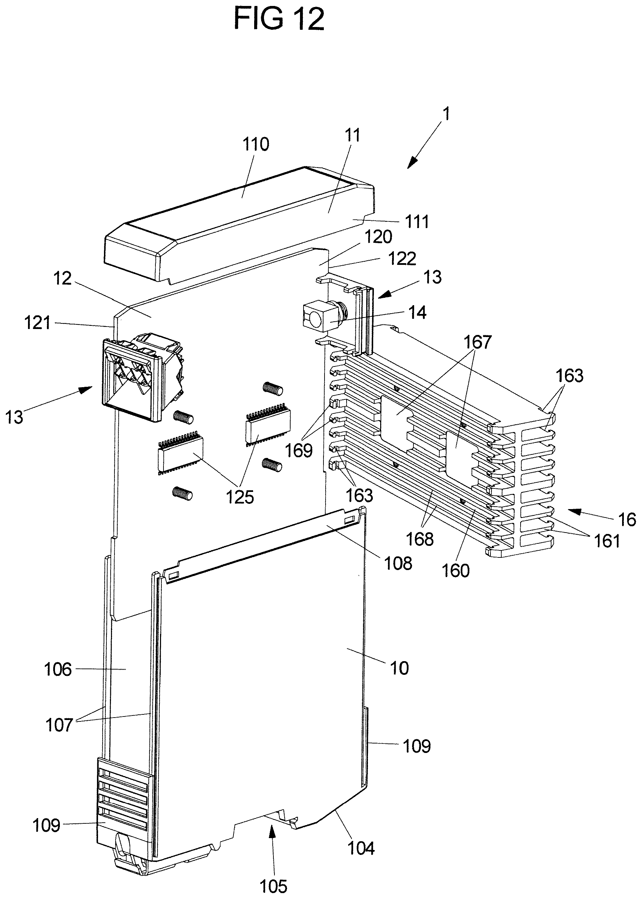

Wie aus Fig. 12 ersichtlich ist, ist das Kühlelement 16 mit einem Bodenabschnitt 160 an die Oberseite 120 der Leiterplatte 12 angesetzt, wobei an dem Bodenabschnitt 160 an einer der Leiterplatte 12 zugewandten Seite Rippen 168 geformt sind, über die der Bodenabschnitt 160 an der Leiterplatte 12 abgestützt ist. Die Rippen 168 sind hierbei bereichsweise zur Ausbildung von Aufnahmeräumen 167 unterbrochen, in denen bei an der Leiterplatte 12 montiertem Kühlelement 16 elektronische Bauelemente 125 einliegen und derart in Wärmeleitverbindung mit dem Kühlelement 16 stehen, dass Wärme von den Bauelementen 125 in das Kühlelement 16 eingeleitet und darüber abgeleitet werden kann.

Bei allen dargestellten Ausführungsbeispielen weisen die Kühlelemente 16 und die Ansetzteile 13 jeweils zwei erste Führungseinrichtungen 163 in Form einer Nut auf, die mit Führungsstegen 107 an den seitlichen Kanten der Seitenwandungen 100, 101 in Eingriff gebracht werden können, um die Kühlelemente 16 und die Ansetzteile 13 auf die Seitenwandungen 100, 101 aufzuschieben und so die Leiterplatte 12 in den Aufnahmeraum 15 des Gehäuses 10 einzuführen.

Der Aufnahmeraum 15 ist zwischen den Seitenwandungen 100, 101 gebildet, die entlang der Anreihrichtung T voneinander beabstandet sind und im Bereich der Stirnseiten 102, 103 oberhalb je eines unteren, feststehenden Wandungsabschnitts 109 Gehäuseöffnungen 106 freigeben. Durch Aufschieben der Kühlelemente 16 und der Ansetzteile 13 mit den Nuten der Führungseinrichtungen 163 auf die Führungsstege 107 der Seitenwandungen 100, 101 werden die Kühlelemente 16 und die Ansetzteile 13 derart zwischen die Seitenwandungen 100, 101 geschoben, dass die Öffnungen 106 im Bereich der Stirnseiten 102, 103 zumindest teilweise verschlossen werden und das Gehäuse 10 an seinen Stirnseiten 102, 103 somit durch die unteren, feststehenden Wandungsabschnitte 109 zusammen mit den Kühlelementen 16 und den Ansetzteilen 13 komplettiert ist.

Nach Einsetzen der aus den Kühlelementen 16, den Ansetzteilen 13 und der Leiterplatte 12 bestehenden vormontierten Baueinheit wird das Gehäuse 10 durch einen Gehäusedeckel 11 verschlossen, sodass die Leiterplatte 12 nicht aus dem Aufnahmeraum 15 herausfallen kann und somit in dem Aufnahmeraum 15 gesichert ist. Der Gehäusedeckel 11 weist bei den dargestellten Ausführungsbeispielen, wie dies zum Beispiel aus Fig. 2 ersichtlich ist, einen Körper 110 auf, an dem seitliche Stege 111 gebildet sind, die mit Verbindungstegen 108 an den oberen Kanten der Seitenwandungen 100, 101 verrasten, wenn der Gehäusedeckel 11 an das Gehäuse 10 angesetzt wird.

In der Montagestellung ist die Leiterplatte 12 in dem Aufnahmeraum 15 des Gehäuses 10 eingefasst. Die Seitenwandungen 100, 101 sind seitlich über die Kühlelemente 16 und die Ansetzteile 13 miteinander verbunden, sodass der Aufnahmeraum 15 des Gehäuses 10 seitlich über die Kühlelemente 16 und die Ansetzteile 13 abgeschlossen ist.

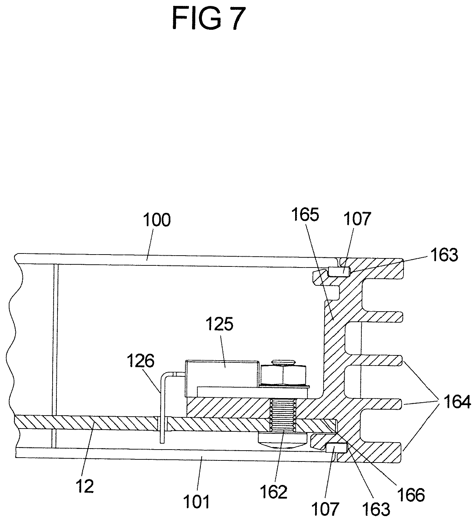

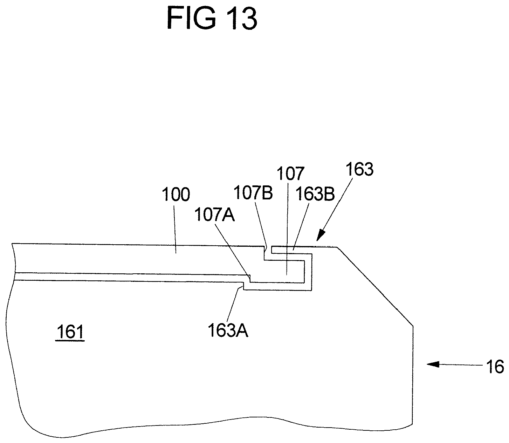

Das Ansetzen der Kühlelemente 16 und der Ansetzteile 13 an die Seitenwandungen 100, 101 des Gehäuses 10 erfolgt in geführter Weise, indem die ersten Führungseinrichtungen 163 der Kühlelemente 16 und der Ansetzteile 13 mit den zweiten Führungseinrichtungen 107 der Seitenwandungen 100, 101 formschlüssig in Eingriff gebracht werden und die Kühlelemente 16 und die Ansetzteile 13 in die Einschubrichtung E in geführter Weise zu den Seitenwandungen 100, 101 verschoben werden. Wie dies zum Beispiel aus den Ansichten gemäß Fig. 4 und Fig. 7 sowie der schematischen Darstellung gemäß Fig. 13 ersichtlich ist, sind die Führungseinrichtungen 163 der Kühlelemente 16 und der Ansetzteile 13 durch Nuten gebildet, die längs entlang der Einschubrichtung E erstreckt sind und einen Eingriff mit einem jeweils zugeordneten Führungssteg 107 an der Seitenkante einer zugeordneten Seitenwandung 100, 101 bereitstellen derart, dass eine in einer Ebene senkrecht zur Einschubrichtung E feste Verbindung zwischen den Kühlelementen 16 und den Ansetzteilen 13 einerseits und den Seitenwandungen 101, 101 andererseits geschaffen wird, die Kühlelemente 16 und die Ansetzteile 13 entlang der Einschubrichtung E aber zu den Seitenwandungen 100, 101 verschiebbar sind. Eine jede Führungseinrichtung 163 der Kühlelemente 16 und der Ansetzteile 13 weist hierzu einen rückseitig der Nut geformten, entlang der Einschubrichtung E erstreckten Blockiersteg 163A auf, der den Eingriff eines zugeordneten Führungsstegs 107 in der Nut der Führungseinrichtung 163 sichert derart, dass der Führungssteg 107 nicht entlang der Querrichtung Q außer Eingriff von der Nut der Führungseinrichtung 163 gelangen kann.

Ein jeder Führungssteg 107 bildet zu der zugeordneten Seitenwandung 100, 101 Stufen 107A, 107B aus, die mit dem Blockiersteg 163A sowie mit einem äußeren Begrenzungsabschnitt 163B der Nut der Führungseinrichtung 163 in Anlage sind, sodass darüber der Führungssteg 107 gleitend in der Führungseinrichtung 163 des zugeordneten Kühlungselements 16 bzw. Ansetzteils 13 gehalten ist und nicht, betrachtet in einer Ebene quer zur Einschubrichtung E, aus der Not heraus gelangen kann, wie dies in Fig. 13 dargestellt ist. Es besteht somit ein formschlüssiger Umgriff für den Führungssteg 107 in der Nut der Führungseinrichtung 163, aufgrund dessen der Führungssteg 107 in der Führungseinrichtung 163 formschlüssig (aber entlang der Einschubrichtung E verschiebbar) gehalten ist.

Die Ausgestaltung der Führungseinrichtungen 163 und der Führungsstege 107 bewirkt, dass sowohl die Kühlelemente 16 als auch die Ansetzteile 13 in definierter Weise auf die Seitenwandungen 100, 101 aufgeschoben werden können. Dies bewirkt zudem, dass in der Montagestellung eine feste Verbindung zwischen den Kühlelementen 16, den Ansetzteilen 13 und den Seitenwandungen 100, 101 geschaffen wird, die belastbar ist und ein (ungewolltes) Lösen der Kühlelemente 16 und der Ansetzteile 13 von den Seitenwandungen 100, 101 zuverlässig verhindert.

Die Kühlelemente 16 und die Ansetzteile 13 weisen funktional identische, im Querschnitt quer zur Einschubrichtung E gleich geformte Führungseinrichtungen 163 in Form von Nuten zur Führung der durch Stege gebildeten Führungseinrichtungen 107 der Seitenwandungen 100, 101 auf. Insbesondere fluchten die Führungseinrichtungen 163 der Kühlelemente 16 und der Ansetzteile 13 (wenn diese mit der Leiterplatte 12 verbunden sind) entlang der Einschubrichtung E miteinander, sodass durchgängige Führungsnuten geschaffen werden, in die die Führungseinrichtungen 107 in Form der Stege der Seitenwandungen 100, 101 zur Montage der Leiterplatte 12 in dem Aufnahmeraum 15 des Gehäuses 10 eingeschoben werden können.

Die Kühlelemente 16 weisen, wenn sie wie bei dem Ausführungsbeispiel gemäß Fig. 5 bis 7 an einer Seitenkante 121, 122 der Leiterplatte 12 angesetzt sind, ein Paar von Führungseinrichtungen 163 zur Führung an einer Stirnseite 102, 103 des Gehäuses 10 auf. Erstrecken sich die Kühlelemente 16, wie bei den Ausführungsbeispielen gemäß Fig. 1 bis 4, Fig. 8 und 9 und Fig. 10 bis 12, entlang der Querrichtung Q über die Leiterplatte 12 hinweg, so weisen die Kühlelemente 16 jeweils zwei Paare von Führungseinrichtungen 163 zur Führung an den beiden gegenüberliegenden Stirnseiten 102, 103 des Gehäuses 10 auf.

Die Kühlelemente 16 und die Ansetzteile 13 sind Bestandteil eines Baukastensystems und können in einer gewünschten Kombination ausgewählt werden, um ein Elektronikgerät 1 mit bestimmungsgemäßer Funktionalität herzustellen. Die Ansetzteile 13 können hierbei ganz unterschiedliche Funktionen übernehmen und können ganz unterschiedlich gestaltet sein. Denkbar ist hierbei, die Leiterplatte 12 ausschließlich mit gleichgearteten oder unterschiedlichen Kühlelementen 16 zu bestücken. Denkbar ist zudem aber auch, an die Leiterplatte 12 ausschließlich Ansetzteile 13 anzusetzen. Schließlich ist denkbar, an die Leiterplatte 12 eine Kombination von Kühlelementen 16 und Ansetzteilen 13 anzusetzen.

Die Kühlelemente 16 sind aus einem gut wärmeleitfähigen Material, insbesondere einem Metallmaterial, zum Beispiel einem Kupfermaterial oder einem Aluminiummaterial gefertigt. Über die Kühlelemente 16 kann somit eine günstige Wärmeableitung von Bauelementen 125 des Elektronikgeräts 1 bereitgestellt werden.

Der der Erfindung zugrunde liegende Gedanke ist nicht auf die vorangehenden Ausführungsbeispiele beschränkt, sondern lässt sich auch in gänzlich andersgearteter Weise jedoch innerhalb der Grenzen der angehängten Ansprüche verwirklichen.

Ein Elektronikgerät der hier beschriebenen Art kann ganz unterschiedliche Funktionen zum Beispiel zum Steuern von elektrischen Maschinen, zum Auswerten von Sensorsignalen, zum Bereitstellen einer Stromversorgung oder dergleichen übernehmen. Ein Elektronikgerät der hier beschriebenen Art kann hierbei mit anderen elektrischen oder elektronischen Baugruppen an einer Tragschiene kombiniert werden, sodass eine komplexe elektrische Anlage zum Beispiel in einem Schaltschrank geschaffen werden kann.

Ein Baukastensystem der hier beschriebenen Art zur Herstellung eines Elektronikgeräts kann vorzugsweise Kühlelemente und Ansetzteile umfassen. Ein Baukastensystem kann jedoch auch nur Kühlelemente aufweisen, die an eine Leiterplatte zum Montieren in einem Gehäuse angeordnet werden können.

### Bezugszeichenliste

- 1: Elektronikgerät
- 10: Gehäuse
- 100, 101: Seitenwandung
- 102, 103: Stirnseite
- 104: Unterseite
- 105: Befestigungseinrichtung
- 106: Öffnung
- 107: Führungskante
- 107A, 107B: Stufe
- 108: Verbindungssteg
- 109: Wandungsabschnitt
- 11: Gehäusedeckel
- 110: Körper
- 111: Steg
- 12: Leiterplatte
- 120: Oberfläche
- 121, 122: Seitenkante
- 125: Bauelemente
- 126: Kontaktarme
- 13: Ansetzteil
- 14: Anschlusseinrichtung
- 15: Aufnahmeraum
- 16: Kühlelement
- 160: Bodenabschnitt
- 161: Querwandung
- 162: Befestigungseinrichtung
- 163: Führungseinrichtung
- 163A: Blockiersteg
- 163B: Begrenzungsabschnitt
- 164: Rippenabschnitt (Überstand)
- 165: Wandungsabschnitt
- 166: Eingriffsaufnahme
- 167: Aufnahmeraum
- 168: Rippen
- 2: Tragschiene
- E: Einschubrichtung
- Q: Querrichtung
- T: Anreihrichtung
- X1, X2: Teilung

## Patentansprüche

1. Baukastensystem zum Herstellen eines entlang einer Anreihrichtung (T) mit anderen Elektronikgehäusen anreihbaren Elektronikgeräts (1), mit einem Gehäuse (10), das einen Aufnahmeraum (15) ausbildet, und einer Leiterplatte (12), die entlang einer Einschubrichtung (E) in den Aufnahmeraum (15) des Gehäuses (10) einsetzbar und in einer Montagestellung in dem Aufnahmeraum (15) aufgenommen ist, **gekennzeichnet durch** zumindest ein Kühlelement (16), das eine erste Führungseinrichtung (163) zur Führung an einer zweiten Führungseinrichtung (107) des Gehäuses (10) aufweist, wobei das zumindest eine Kühlelement (16) derart mit der Leiterplatte (12) verbindbar ist, dass bei Einsetzen der Leiterplatte (12) in den Aufnahmeraum (15) das zumindest eine Kühlelement (16) über die erste Führungseinrichtung (163) an der zweiten Führungseinrichtung (107) des Gehäuses (10) entlang der Einschubrichtung (E) verschiebbar geführt ist.

2. Baukastensystem nach Anspruch 1, **dadurch gekennzeichnet, dass** das Gehäuse (10) zwei entlang der Anreihrichtung (T) zueinander beabstandete, zwischen sich den Aufnahmeraum (15) ausbildende Seitenwandungen (100, 101) aufweist, wobei die Leiterplatte (12) in der Montagestellung in einer senkrecht zur Anreihrichtung (T) erstreckten Stellung in dem Aufnahmeraum (15) aufgenommen ist.

3. Baukastensystem nach Anspruch 2, **dadurch gekennzeichnet, dass** das zumindest eine Kühlelement (16) in der Montagestellung die Seitenwandungen (100, 101) formschlüssig miteinander verbinden.

4. Baukastensystem nach Anspruch 2 oder 3, **dadurch gekennzeichnet, dass** das zumindest eine Kühlelement (16) zwei erste Führungseinrichtungen (163) und jede Seitenwandung (100, 101) eine zweite Führungseinrichtung (107) aufweist.

5. Baukastensystem nach Anspruch 4, **dadurch gekennzeichnet, dass** zur Montage des Gehäuses (10) die ersten Führungseinrichtungen (163) und die zweiten Führungseinrichtungen (107) derart miteinander in Eingriff bringbar sind, dass das zumindest eine Kühlelement (16) in einer senkrecht zur Einschubrichtung (E) erstreckten Ebene fest mit den Seitenwandungen (100, 101) verbunden ist, entlang der Einschubrichtung (E) aber zu den Seitenwandungen (100, 101) verschiebbar ist.

6. Baukastensystem nach Anspruch 4 oder 5, **dadurch gekennzeichnet, dass** jede erste Führungseinrichtung (163) mit einer zugeordneten zweiten Führungseinrichtung (107) formschlüssig durch Eingriff eines Stegs (107) in eine Nut in Eingriff bringbar ist.

7. Baukastensystem nach einem der Ansprüche 4 bis 6, **dadurch gekennzeichnet, dass** die zweiten Führungseinrichtungen (107) jeweils einen Steg und die ersten Führungseinrichtungen (163) jeweils eine mit dem Steg einer zugeordneten zweiten Führungseinrichtung (163) in Eingriff bringbare Nut aufweisen.

8. Baukastensystem nach Anspruch 6 oder 7, **dadurch gekennzeichnet, dass** die ersten Führungseinrichtungen (163) je einen Blockiersteg (163A) aufweisen, der die Nut entlang einer senkrecht zur Einschubrichtung (E) und senkrecht zur Anreihrichtung (T) erstreckten Querrichtung (Q) begrenzt derart, dass der zugeordnete Steg entlang der Querrichtung (Q) in Eingriff mit der Nut gehalten wird.

9. Baukastensystem nach einem der vorangehenden Ansprüche, **dadurch gekennzeichnet, dass** das zumindest eine Kühlelement (16) einen Bodenabschnitt (160) aufweist, über den das zumindest eine Kühlelement (16) mit der Leiterplatte (12) verbindbar ist.

10. Baukastensystem nach Anspruch 9, **dadurch gekennzeichnet, dass** zumindest ein zu kühlendes, elektrisch mit der Leiterplatte (12) verbundenes Bauelement (125) an dem Bodenabschnitt (160) angeordnet ist.

11. Baukastensystem nach Anspruch 9 oder 10, **dadurch gekennzeichnet, dass** das zumindest eine Kühlelement (16) zumindest eine Querwandung (161) aufweist, die sich entlang einer senkrecht zur Einschubrichtung (E) erstreckten Ebene von dem Bodenabschnitt (160) erstreckt.

12. Baukastensystem nach Anspruch 11, **dadurch gekennzeichnet, dass** zumindest ein zu kühlendes, elektrisch mit der Leiterplatte (12) verbundenes Bauelement (125) an der zumindest einen Querwandung (161) angeordnet ist.

13. Baukastensystem nach Anspruch 11 oder 12, **dadurch gekennzeichnet, dass** das zumindest eine Kühlelement (16) mindestens zwei parallel zueinander erstreckte, entlang der Einschubrichtung (E) zueinander beabstandete Querwandungen (161) aufweist, die zwischen sich einen Strömungskanal für eine Luftströmung durch den Aufnahmeraum (15) hindurch bilden.

14. Baukastensystem nach einem der vorangehenden Ansprüche, **dadurch gekennzeichnet, dass** das zumindest eine Kühlelement (16) zumindest einen Rippenabschnitt (164) aufweist, der entlang einer Richtung quer zur Einschubrichtung (E) und quer zur Anreihrichtung (T) von dem Gehäuse (10) vorsteht.

15. Baukastensystem nach Anspruch 14, **dadurch gekennzeichnet, dass** das zumindest eine Kühlelement (16) einen entlang der Einschubrichtung (E) und der Anreihrichtung (T) flächig erstreckten Wandungsabschnitt (165) aufweist, von dem der zumindest eine Rippenabschnitt (164) vorsteht.

16. Baukastensystem nach einem der vorangehenden Ansprüche, **gekennzeichnet durch** eine Mehrzahl von mit der Leiterplatte (12) verbindbaren Ansetzteilen (13), die jeweils, betrachtet entlang der Einschubrichtung (E), eine Teilung (X1, X2) aufweisen, die einer vorbestimmten kleinsten Teilungseinheit (X1) oder einem ganzzahligen Vielfachen der vorbestimmten kleinsten Teilungseinheit (X1) entspricht, wobei auch jedes Ansetzteil (13) eine erste Führungseinrichtung (163) zur Führung an der zweiten Führungseinrichtung (107) des Gehäuses (10) aufweist und eine Kombination von Ansetzteilen (13) zusammen mit dem zumindest einen Kühlelement (16) entlang der Einschubrichtung (E) aneinander angereiht mit der Leiterplatte (12) derart verbindbar ist, dass bei Einsetzen der Leiterplatte (12) in den Aufnahmeraum (15) die Kombination von Ansetzteilen (13) und das zumindest eine Kühlelement (16) über die ersten Führungseinrichtungen (163) an der zweiten Führungseinrichtung (107) des Gehäuses (10) entlang der Einschubrichtung (E) verschiebbar geführt ist.

17. Baukastensystem nach Anspruch 16, **dadurch gekennzeichnet, dass** das zumindest eine Kühlelement (16), betrachtet entlang der Einschubrichtung (E), eine Teilung (X1, X2) aufweist, die der vorbestimmten kleinsten Teilungseinheit (X1) oder einem ganzzahligen Vielfachen der vorbestimmten kleinsten Teilungseinheit (X1) entspricht.

18. Baukastensystem nach Anspruch 16 oder 17, **dadurch gekennzeichnet, dass** die Kombination von Ansetzteilen (13) in der Montagestellung eine Begrenzung für den Aufnahmeraum (15) nach außen hin bildet.

19. Baukastensystem nach einem der Ansprüche 16 bis 18, **dadurch gekennzeichnet, dass** die Leiterplatte (12) entlang der Einschubrichtung (E) erstreckte, gegenüberliegende Seitenkanten (121, 122) aufweist, wobei die Kombination von Ansetzteilen (13) an einer der Seitenkanten (121, 122) mit der Leiterplatte (12) verbindbar ist.

20. Baukastensystem nach einem Ansprüche 16 bis 19, **dadurch gekennzeichnet, dass** die Kombination von Ansetzteilen (13) stoffschlüssig, kraftschlüssig oder formschlüssig mit der Leiterpatte (12) verbindbar ist.

21. Baukastensystem nach einem der vorangehenden Ansprüche, **gekennzeichnet durch** eine Befestigungseinrichtung (105) zum Verbinden des Elektronikgeräts (1) mit einer Tragschiene (2).

22. Verfahren zum Herstellen eines entlang einer Anreihrichtung (T) mit anderen Elektronikgehäusen anreihbaren Elektronikgeräts (1) unter Verwendung eines Baukastensystems, bei dem eine Leiterplatte (12) entlang einer Einschubrichtung (E) in einen Aufnahmeraum (15) eines Gehäuses (10) eingesetzt wird und in einer Montagestellung in dem Aufnahmeraum (15) aufgenommen ist, **dadurch gekennzeichnet, dass** zum Herstellen des Elektronikgeräts (1) zumindest ein Kühlelement (16), das eine erste Führungseinrichtung (163) zur Führung an einer zweiten Führungseinrichtung (107) des Gehäuses (10) aufweist, mit der Leiterplatte (12) verbunden wird und bei Einsetzen der Leiterplatte (12) in den Aufnahmeraum (15) das zumindest eine Kühlelement (16) über die erste Führungseinrichtung (163) an der zweiten Führungseinrichtung (107) des Gehäuses (10) entlang der Einschubrichtung (E) verschiebbar geführt wird.

## Claims

1. Modular system for producing an electronic device (1) which can be lined up with other electronics housings along a lining-up direction (T), having a housing (10), which configures a receiving space (15), and having a printed circuit board (12) which can be inserted into the receiving space (15) of the housing (10) along an insertion direction (E) and which is received in the receiving space (15) in an assembly position, **characterized by** at least one cooling element (16) which has a first guide apparatus (163) for guidance on a second guide apparatus (107) of the housing (10), wherein the at least one cooling element (16) can be connected to the printed circuit board (12) in such a way that, when the printed circuit board (12) is inserted into the receiving space (15), the at least one cooling element (16) is guided, by way of the first guide apparatus (163), on the second guide apparatus (107) of the housing (10) in a displaceable manner along the insertion direction (E).

2. Modular system according to Claim 1, **characterized in that** the housing (10) has two side walls (100, 101) which are spaced apart from one another along the lining-up direction (T) and which between them configure the receiving space (15), wherein, in the assembly position, the printed circuit board (12) is received in the receiving space (15) in a position extending perpendicularly with respect to the lining-up direction (T).

3. Modular system according to Claim 2, **characterized in that**, in the assembly position, the at least one cooling element (16) connects the side walls (100, 101) to one another in a positively locking manner.

4. Modular system according to Claim 2 or 3, **characterized in that** the at least one cooling element (16) has two first guide apparatuses (163), and each side wall (100, 101) has a second guide apparatus (107).

5. Modular system according to Claim 4, **characterized in that**, in order to assemble the housing (10), the first guide apparatuses (163) and the second guide apparatuses (107) can be brought into engagement with one another in such a way that the at least one cooling element (16) is fixedly connected to the side walls (100, 101) in a plane extending perpendicularly with respect to the insertion direction (E) but can be displaced relative to the side walls (100, 101) along the insertion direction (E) .

6. Modular system according to Claim 4 or 5, **characterized in that** each first guide apparatus (163) can be brought into engagement with an associated second guide apparatus (107) in a positively locking manner as a result of engagement of a web (107) into a groove.

7. Modular system according to one of Claims 4 to 6, **characterized in that** each of the second guide apparatuses (107) has a web and each of the first guide apparatuses (163) has a groove which can be brought into engagement with the web of an associated second guide apparatus (163).

8. Modular system according to Claim 6 or 7, **characterized in that** the first guide apparatuses (163) have a respective blocking web (163A) which delimits the groove along a transverse direction (Q), extending perpendicularly with respect to the insertion direction (E) and perpendicularly with respect to the lining-up direction (T), in such a way that the associated web is held in engagement with the groove along the transverse direction (Q).

9. Modular system according to one of the preceding claims, **characterized in that** the at least one cooling element (16) has a base portion (160), by way of which the at least one cooling element (16) can be connected to the printed circuit board (12).

10. Modular system according to Claim 9, **characterized in that** at least one structural element (125) to be cooled, which is electrically connected to the printed circuit board (12), is arranged on the base portion (160).

11. Modular system according to Claim 9 or 10, **characterized in that** the at least one cooling element (16) has at least one transverse wall (161) which extends from the base portion (160) along a plane extending perpendicularly with respect to the insertion direction (E).

12. Modular system according to Claim 11, **characterized in that** at least one structural element (125) to be cooled, which is electrically connected to the printed circuit board (12), is arranged on the at least one transverse wall (161).

13. Modular system according to Claim 11 or 12, **characterized in that** the at least one cooling element (16) has at least two transverse walls (161) which extend parallel to one another, which are spaced apart from one another along the insertion direction (E) and which between them form a flow channel for an air flow through the receiving space (15) .

14. Modular system according to one of the preceding claims, **characterized in that** the at least one cooling element (16) has at least one rib portion (164) which protrudes from the housing (10) along a direction transverse to the insertion direction (E) and transverse to the lining-up direction (T).

15. Modular system according to Claim 14, **characterized in that** the at least one cooling element (16) has a wall portion (165) which extends in an areal manner along the insertion direction (E) and the lining-up direction (T) and from which the at least one rib portion (164) protrudes.

16. Modular system according to one of the preceding claims, **characterized by** a plurality of attachment parts (13) which can be connected to the printed circuit board (12) and which in each case have, as viewed along the insertion direction (E), a pitch (X1, X2) which corresponds to a predetermined smallest pitch unit (X1) or to an integer multiple of the predetermined smallest pitch unit (X1), wherein each attachment part (13) also has a first guide apparatus (163) for guidance on the second guide apparatus (107) of the housing (10), and a combination of attachment parts (13), together with the at least one cooling element (16), lined up against one another along the insertion direction (E), can be connected to the printed circuit board (12) in such a way that, when the printed circuit board (12) is inserted into the receiving space (15), the combination of attachment parts (13) and the at least one cooling element (16) are guided, by way of the first guide apparatuses (163), on the second guide apparatus (107) of the housing (10) in a displaceable manner along the insertion direction (E) .

17. Modular system according to Claim 16, **characterized in that** the at least one cooling element (16) has, as viewed along the insertion direction (E), a pitch (X1, X2) which corresponds to the predetermined smallest pitch unit (X1) or to an integer multiple of the predetermined smallest pitch unit (X1).

18. Modular system according to Claim 16 or 17, **characterized in that**, in the assembly position, the combination of attachment parts (13) forms a delimitation for the receiving space (15) towards the outside.

19. Modular system according to one of Claims 16 to 18, **characterized in that** the printed circuit board (12) has opposite side edges (121, 122) which extend along the insertion direction (E), wherein the combination of attachment parts (13) can be connected to the printed circuit board (12) at one of the side edges (121, 122).

20. Modular system according to one of Claims 16 to 19, **characterized in that** the combination of attachment parts (13) can be connected to the printed circuit board (12) in a materially bonded, force-fitting or positively locking manner.

21. Modular system according to one of the preceding claims, **characterized by** a fastening apparatus (105) for connecting the electronic device (1) to a carrier rail (2).

22. Method for producing an electronic device (1) which can be lined up with other electronics housings along a lining-up direction (T) using a modular system, in which a printed circuit board (12) is inserted into a receiving space (15) of a housing (10) along an insertion direction (E) and is received in the receiving space (15) in an assembly position, **characterized in that**, in order to produce the electronic device (1), at least one cooling element (16) which has a first guide apparatus (163) for guidance on a second guide apparatus (107) of the housing (10) is connected to the printed circuit board (12), and, when the printed circuit board (12) is inserted into the receiving space (15), the at least one cooling element (16) is guided, by way of the first guide apparatus (163), on the second guide apparatus (107) of the housing (10) in a displaceable manner along the insertion direction (E) .

## Revendications

1. Système modulaire destiné à la fabrication d'un appareil électronique (1) qui peut être joint à d'autres boîtiers électroniques le long d'une direction de jonction (T), ledit système comprenant un boîtier (10), qui forme un espace de réception (15), et une carte de circuit imprimé (12) qui peut être insérée dans l'espace de réception (15) du boîtier (10) le long d'une direction d'insertion (E) et qui est reçue dans l'espace de réception (15) dans une position de montage, **caractérisé par** au moins un élément de refroidissement (16) qui comporte un premier dispositif de guidage (163) destiné à effectuer un guidage sur un deuxième dispositif de guidage (107) du boîtier (10), l'au moins un élément de refroidissement (16) pouvant être relié à la carte de circuit imprimé (12) de telle sorte que, lorsque la carte de circuit imprimé (12) est insérée dans l'espace de réception (15), l'au moins un élément de refroidissement (16) soit guidé de manière coulissante le long de la direction d'insertion (E) sur le deuxième dispositif de guidage (107) du boîtier (10) par le biais du premier dispositif de guidage (163).

2. Système modulaire selon la revendication 1, **caractérisé en ce que** le boîtier (10) comporte deux parois latérales (100, 101) qui sont espacées l'une de l'autre le long de la direction de jonction (T) et qui forment entre elles l'espace de réception (15), la carte de circuit imprimé (12) étant reçue, dans la position de montage, dans l'espace de réception (15) dans une position s'étendant perpendiculairement à la direction de jonction (T).

3. Système modulaire selon la revendication 2, **caractérisé en ce que** l'au moins un élément de refroidissement (16) relie, dans la position de montage, les parois latérales (100, 101) entre elles par complémentarité de formes.

4. Système modulaire selon la revendication 2 ou 3, **caractérisé en ce que** l'au moins un élément de refroidissement (16) comporte deux premiers dispositifs de guidage (163) et chaque paroi latérale (100, 101) comporte un deuxième dispositif de guidage (107).

5. Système modulaire selon la revendication 4, **caractérisé en ce que,** pour effectuer le montage du boîtier (10), les premiers dispositifs de guidage (163) et les deuxièmes dispositifs de guidage (107) peuvent être amenés en engagement les uns avec les autres de telle sorte que l'au moins un élément de refroidissement (16) est relié de manière fixe aux parois latérales (100, 101) dans un plan s'étendant perpendiculairement à la direction d'insertion (E), mais peut coulisser vers les parois latérales (100, 101) le long de la direction d'insertion (E).

6. Système modulaire selon la revendication 4 ou 5, **caractérisé en ce que** chaque premier dispositif de guidage (163) peut être amené en engagement par complémentarité de formes avec un deuxième dispositif de guidage associé (107) par engagement d'une nervure (107) dans une rainure.

7. Système modulaire selon l'une des revendications 4 à 6, **caractérisé en ce que** les deuxièmes dispositifs de guidage (107) comportent chacun une nervure et les premiers dispositifs de guidage (163) comportent chacun une rainure pouvant être amenée en engagement avec la nervure d'un deuxième dispositif de guidage associé (163) .

8. Système modulaire selon la revendication 6 ou 7, **caractérisé en ce que** les premiers dispositifs de guidage (163) comportent chacun une nervure de blocage (163A) qui délimite la rainure le long d'une direction transversale (Q) s'étendant perpendiculairement à la direction d'insertion (E) et perpendiculairement à la direction de jonction (T) de sorte que la nervure associée soit maintenue en engagement avec la rainure le long de la direction transversale (Q).

9. Système modulaire selon l'une des revendications précédentes, **caractérisé en ce que** l'au moins un élément de refroidissement (16) comporte une portion de fond (160) permettant de relier l'au moins un élément de refroidissement (16) à la carte de circuit imprimé (12).

10. Système modulaire selon la revendication 9, **caractérisé en ce qu'**au moins un composant (125) à refroidir, relié électriquement à la carte de circuit imprimé (12), est disposé au niveau de la portion de fond (160) .

11. Système modulaire selon la revendication 9 ou 10, **caractérisé en ce que** l'au moins un élément de refroidissement (16) comporte au moins une paroi transversale (161) qui s'étend depuis la portion de fond (160) le long d'un plan s'étendant perpendiculairement à la direction d'insertion (E).

12. Système modulaire selon la revendication 11, **caractérisé en ce qu'**au moins un composant (125) à refroidir, relié électriquement à la carte de circuit imprimé (12) est disposé au niveau de l'au moins une paroi transversale (161).

13. Système modulaire selon la revendication 11 ou 12, **caractérisé en ce que** l'au moins un élément de refroidissement (16) comporte au moins deux parois transversales (161) s'étendant parallèlement l'une à l'autre et espacées l'une de l'autre le long de la direction d'insertion (E), lesquelles forment entre elles un canal d'écoulement destiné à un écoulement d'air à travers l'espace de réception (15).

14. Système modulaire selon l'une des revendications précédentes, **caractérisé en ce que** l'au moins un élément de refroidissement (16) comporte au moins une portion formant ailette (164) qui fait saillie depuis le boîtier (10) le long d'une direction transversale à la direction d'insertion (E) et transversale à la direction de jonction (T).

15. Système modulaire selon la revendication 14, **caractérisé en ce que** l'au moins un élément de refroidissement (16) comporte une portion de paroi (165) qui s'étend de manière bidimensionnelle le long de la direction d'insertion (E) et de la direction de jonction (T) et de laquelle l'au moins une portion formant ailette (164) fait saillie.

16. Système modulaire selon l'une des revendications précédentes, **caractérisé par** une pluralité de pièces de fixation (13) qui peuvent être reliées à la carte de circuit imprimé (12) et qui, vues le long de la direction d'insertion (E), ont une division (X1, X2) qui correspond à une plus petite unité de division prédéterminée (X1) ou à un multiple entier de la plus petite unité de division prédéterminée (X1), chaque pièce de fixation (13) comportant également un premier dispositif de guidage (163) destiné à effectuer le guidage sur le deuxième dispositif de guidage (107) du boîtier (10) et une combinaison de pièces de fixation (13) pouvant être reliées, conjointement avec l'au moins un élément de refroidissement (16), à la carte de circuit imprimé (12) en étant jointes les unes aux autres le long de la direction d'insertion (E) de telle sorte que, lorsque la carte de circuit imprimé (12) est insérée dans l'espace de réception (15), la combinaison de pièces de fixation (13) et l'au moins un élément de refroidissement (16) soient guidés de manière coulissante le long de la direction d'insertion (E) sur le deuxième dispositif de guidage (107) du boîtier (10) par le biais des premiers dispositifs de guidage (163).

17. Système modulaire selon la revendication 16, **caractérisé en ce que** l'au moins un élément de refroidissement (16) présente, vu le long de la direction d'insertion (E), une division (X1, X2) qui correspond à la plus petite unité de division prédéterminée (X1) ou à un multiple entier de la plus petite unité de division prédéterminée (X1).

18. Système modulaire selon la revendication 16 ou 17, **caractérisé en ce que** la combinaison de pièces de fixation (13) forme, dans la position de montage, une limitation de l'espace de réception (15) vers l'extérieur.

19. Système modulaire selon l'une des revendications 16 à 18, **caractérisé en ce que** la carte de circuit imprimé (12) comporte des bords latéraux opposés (121, 122) s'étendant le long de la direction d'insertion (E), la combinaison de pièces de fixation (13) pouvant être reliées à la carte de circuit imprimé (12) au niveau de l'un des bords latéraux (121, 122).

20. Système modulaire selon l'une des revendications 16 à 19, **caractérisé en ce que** la combinaison de pièces de fixation (13) peut être reliée à la carte de circuit imprimé (12) par une liaison de matière, une liaison en force ou une liaison par complémentarité de formes.

21. Système modulaire selon l'une des revendications précédentes, **caractérisé par** un dispositif de fixation (105) destiné à relier l'appareil électronique (1) à un rail de support (2).

22. Procédé de fabrication d'un appareil électronique (1), qui peut être joint à d'autres boîtiers électroniques le long d'une direction de jonction (T), à l'aide d'un système modulaire dans lequel une carte de circuit imprimé (12) est insérée, le long d'une direction d'insertion (E), dans un espace de réception (15) d'un boîtier (10) et est reçue, dans une position de montage, dans l'espace de réception (15), **caractérisé en ce que,** pour fabriquer l'appareil électronique (1), au moins un élément de refroidissement (16), qui comporte un premier dispositif de guidage (163) destiné à effectuer le guidage sur un deuxième dispositif de guidage (107) du boîtier (10), est relié à la carte de circuit imprimé (12) et, lorsque la carte de circuit imprimé (12) est insérée dans l'espace de réception (15), l'au moins un élément de refroidissement (16) est guidé de manière coulissante le long de la direction d'insertion (E) sur le deuxième dispositif de guidage (107) du boîtier (10) par le biais du premier dispositif de guidage (163).
